# EUROPÄISCHE PATENTANMELDUNG

(11) **EP 1 855 324 A1**
(43) Veröffentlichungstag der Anmeldung: **14.11.2007**
(21) Anmeldenummer: 06009859.7
(22) Anmeldetag: 12.05.2006
(51) Int. Cl.: H01L 31/042, C03C 10/00

(54) **Substratträger aus glaskeramischen Material**

(71) Anmelder: Applied Materials GmbH & Co. KG, 63755 Alzenau (DE)
(72) Erfinder: Ulrich, Jürgen, 61137 Schöneck (DE)
(74) Vertreter: GROSSE BOCKHORNI SCHUMACHER

(57) **Zusammenfassung**

Die vorliegende Erfindung zeigt eine Beschichtungsanlage mit einem neuartigen Substratträger (1) auf. Der Substratträger (1) besteht dabei im Wesentlichen aus einer Platte (2) aus Glaskeramik. Glaskeramisches Material ist im Vergleich zu bisher gebräuchlichem CFC-Material kostengünstiger und weist eine kürzere Lieferzeit auf. Somit lässt sich die Beschichtungsanlage wirtschaftlicher betreiben.

## Beschreibung

Die vorliegende Erfindung betrifft eine Beschichtungsanlage für die Substratbeschichtung gemäß Oberbegriff von Anspruch 1 und die Verwendung eines Materials für einen Substratträger für die Substratbeschichtung gemäß Oberbegriff von Anspruch 15.

Beschichtungsanlagen für die Substratbeschichtung, insbesondere Beschichtungsanlagen für die Herstellung von Solarzellen mittels Vakuumabscheideverfahren, wie PVD (physical vapor deposition), weisen üblicherweise einen Substratträger auf, der zur Aufnahme von ein oder mehreren Substraten, z. B. Siliziumwafem, angepasst ist. Ein solcher Substratträger dient dabei nicht nur der Aufnahme und dem Transport der Substrate innerhalb der Beschichtungsanlage, er dient auch als Träger der Substrate während der Beschichtung, so dass der Substratträger vielfältigen Anforderungen hinsichtlich seiner Materialeigenschaften gerecht werden muss.

Zum einen darf es sich nicht um ein Material handeln, das bei Erwärmung in das Substrat eindiffundiert. Weiterhin muss das Material temperaturbeständig und nur geringer Wärmeausdehnung unterworfen sein. Schließlich ist ein großes Elastizitätsmodul, also eine hohe Steifigkeit, bei geringer Dichte erforderlich, damit der Substratträger im Wesentlichen keiner Verwindung unterworfen wird und die Transportvorrichtung der Beschichtungsanlage für den Substratträger nur gering dimensioniert ausgebildet werden muss.

Üblicherweise bestehen Substratträger bisher aus einem faserverstärktem Verbundstoff, insbesondere aus einem kohlefaserverstärktem Kohlenstoff (CFC), da dieser ein geringes spezifisches Gewicht, eine sehr hohe Steifigkeit auch bei sehr hohen Temperaturen und eine geringe thermische Ausdehnung aufweist.

Nachteilig an einem solchen Substratträger sind jedoch die hohen Kosten und die langen Lieferzeiten, die auf das CFC-Material zurückzuführen sind. Außerdem sind auch CFC-Substratträger bei Aufheizung nicht immer frei von Verwindung.

Aufgabe der vorliegenden Erfindung ist es deshalb, eine Beschichtungsanlage bereitzustellen mit einem verwindungsarmen Substratträger, der einen wirtschaftlicheren, insbesondere kostengünstigeren Gebrauch der Anlage gestattet. Dabei soll der Substratträger einfach und kostengünstig herzustellen sein.

Diese Aufgabe wird gelöst durch eine Beschichtungsanlage gemäß Anspruch 1 und die Verwendung eines Materials für einen Substratträger gemäß Anspruch 15. Vorteilhafte Ausgestaltungen sind Gegenstände der abhängigen Unteransprüche.

Die erfindungsgemäße Beschichtungsanlage, die insbesondere für die Herstellung von Solarzellen Einsatz findet, umfasst einen Substratträger zur Substratbeschichtung der im Wesentlichen aus einem glaskeramischen Material besteht. Glaskeramische Materialien sind temperaturbeständig und weisen von Natur aus ein großes Elastizitätsmodul bei geringer Dichte und eine geringe Wärmeausdehnung auf, dabei ist die Temperaturabhängigkeit des Elastizitätsmoduls geringer als diejenige bei einem CFC-Material, so dass eine geringere Verwindung bei Erwärmung sichergestellt ist. Außerdem lässt sich dieses relativ kostengünstige Material einfach bearbeiten, so dass sich eine kostengünstige Herstellung des Substratträgers und damit ein wirtschaftlicher Betrieb der Beschichtungsanlage erreichen lassen.

Besonders vorteilhaft wird als glaskeramisches Material Schott Robax® benutzt. Dieses Material wird bisher vor allem für den Bau von durchsichtigen Feuerabschottungen, beispielsweise für Kamintüren, verwendet und ist extrem hitzebeständig und weist eine sehr geringe thermische Ausdehnung auf. Dieses kommerziell erhältliche Material ist im Vergleich zu CFC-Material nur etwa halb so teuer und in wesentlich kürzerer Zeit lieferbar. Alternativ ist auch NeoCeram® N-11 der Nippon Electric Glass Co. Ltd. verwendbar, welches ähnliche Eigenschaften aufweist wie Schott Robax®.

Bevorzugt ist der Substratträger als im Wesentlichen rechteckige Platte ausgebildet und weist auf einer Hauptfläche mehrere nebeneinander angeordnete Aufnahmen für die Aufnahme von Substraten auf. Damit lassen sich mehrere Substrate gleichzeitig beschichten.

Besonders bevorzugt sind dabei die Aufnahmen als Vertiefungen in dem Substratträger ausgebildet, da der Substratträger dann besonders einfach herstellbar ist. Wenn dann die einzelnen Substrataufnahmen voneinander durch leistenartige Stege getrennt sind und der Substratträger einen äußeren, die äußeren Aufnahmen begrenzenden stegartigen Rand aufweist, können im Verhältnis zur Substratträgerfläche relative viele Substrate aufgenommen werden, wobei der Substratträger immer noch eine ausreichende Steifigkeit und Stabilität auf weist.

Um Spannungen an den Übergangsstellen zwischen den leistenartigen Stegen untereinander, den einzelnen Seitenbereichen des Randes untereinander bzw. den leistenartigen Stegen und dem äußeren Rand zu vermeiden, sind dort abgerundete Übergänge vorgesehen, so dass die Kanten der leistenartigen Stege aufeinander bzw. der leistenartigen Stege und des Randes nicht in einem rechten Winkel aufeinandertreffen.

Bevorzugt sind dabei die Übergänge als Halbkreise ausgeführt, die sich tangential von einem leistenartigen Steg oder von einem Seitenbereich erstrecken und in einem rechten Winkel in den zu diesem rechtwinklig verlaufenden leistenartigen Steg bzw. Seitenbereich der jeweiligen Aufnahme übergehen.

In einer vorteilhaften Weiterbildung ist der Substratträger mehrstückig ausgebildet, wobei der Substratträger bevorzugt entlang der leistenartigen Stege mit Hilfe die einzelnen Teile verbindender seitlicher Leisten trennbar ausgebildet ist, so dass zu einen je nach Bedarf und Größe der Beschichtungsanlage die Zahl der aufnehmbaren Substrate einfach angepasst werden kann und zum anderen im Falle einer Beschädigung des Substratträgers nicht der gesamte Substratträger ausgetauscht werden muss sondern nur ein Teil davon. Hierdurch wird die Wirtschaftlichkeit noch weiter erhöht.

Vorteilhaft sind in den Aufnahmen vertiefte Auflagen für die Substrate angeordnet. Mit beispielsweise als Freifräsung ausgeführten Auflagen lässt sich sowohl eine liegende Aufnahme der Substrate als auch eine fast senkrechte Aufnahme (5° - 10° Neigung des Substratträgers zur Senkrechten) sicherstellen, da bei vertieften Auflagen mit einer solchen Neigung wirksam ein Herausfallen der Substrate aus dem Substratträger verhindert ist.

Wenn in den Aufnahmen Durchgriffsöffnungen vorgesehen sind, lassen sich die Substrate einfacher handhaben. Insbesondere können die Auflagen dann auch als an zwei Seiten der Aufnahmen gegenüberliegende U-förmige Rillen ausgebildet sein, deren innere Bögen in der Substratträgerebene ausgerichtet sind, wobei der Abstand der inneren Bögen der in einer Aufnahme gegenüberliegenden U-förmigen Rillen größer und der Abstand der äußeren Enden der in einer Aufnahme gegenüberliegenden U-förmigen Rillen kleiner ist als die laterale Abmessung des Substrates. Dabei sind die Rillen in der Richtung gegenüberliegend angeordnet, in der der Substratträger senkrecht gestellt werden soll, wobei der Abstand des inneren Bogens der in Bezug auf den senkrecht gestellten Substratträger obere Rille zu einem äußeren Ende der gegenüberliegenden Rille größer ist als die laterale Abmessung des Substrates. Auf diese Weise kann ein Substrat in leicht zur Senkrechten geneigter Ausrichtung in eine in Bezug auf die senkrechte Stellung des Substratträgers obere Rille eingeführt und nach Schwenken in die Senkrechte in die untere Rille abgesetzt werden, wobei die äußeren Enden der oberen und unteren Rillen das Substrat nun in der Aufnahme halten. Die Abstände der Enden und Bögen müssen dabei nur geringfügig (einige Millimeter) kleiner bzw. größer sein als die laterale Abmessung des Substrates. Durch den geringeren Abstand der Enden der Rillen in Bezug auf die laterale Abmessung des Substrats ist auch eine sichere liegende Aufnahme des Substrats möglich.

Wenn nun zumindest die der Beschichtungsquelle zugewandten äußeren Enden der in einer Aufnahme gegenüberliegenden U-förmigen Rillen teilweise durchbrochen sind, ist nur eine sehr geringe Abschattung des Substrats bei der Beschichtung gegeben.

Selbständiger Schutz wird für die Verwendung eines glaskeramischen Materials für einen Substratträger beansprucht, der insbesondere entsprechend der obigen Vorgaben ausgebildet ist. Bevorzugt wird dabei als glaskeramisches Material das kommerziell erhältliche Schott Robax®-Material oder NeoCeram® N-11, eine aus einer glasigen und einer kristallinen Struktur bestehende Glaskeramik, verwendet, da diese kostengünstiger und kurzfristiger als vergleichbare Materialien, insbesondere CFC, beschafft werden können.

Weitere Kennzeichen, Merkmale und Vorteile der vorliegenden Erfindung ergeben sich aus der nachfolgenden Beschreibung eines in der Zeichnung dargestellten bevorzugten Ausführungsbeispiels. Dabei zeigen
- Fig. 1: einen Substratträger in Draufsicht,
- Fig. 2: einen vergrößerten Bereich des Substratträgers aus Fig. 1 und
- Fig. 3: einen vergrößerten Bereich des Substratträgers aus Fig. 2 und

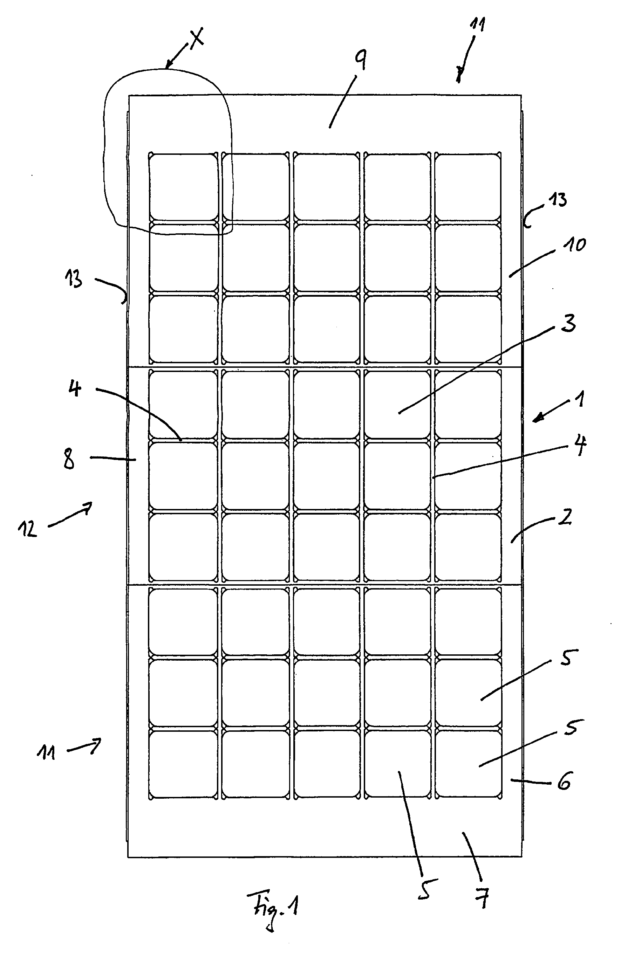

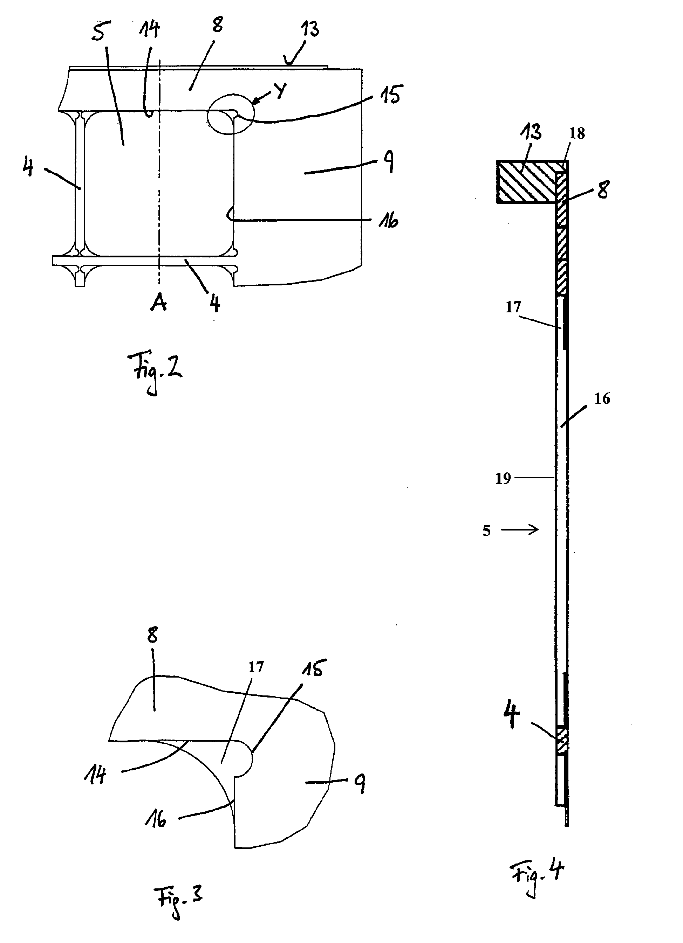

- Fig. 3: eine Querschnittsansicht des vergrößerten Bereichs aus Fig. 2.

In Fig. 1 ist rein schematisch ein Substratträger 1 in einer bevorzugten Ausführungsform der vorliegenden Erfindung in einer Draufsicht dargestellt. Der Substratträger 1 besteht aus einer mehrteiligen Schott Robax®-Glaskeramikplatte 2, die eine rechteckige Grundform aufweist und in der mehrere Aufnahmen 3, 5 schachbrettartig angeordnet sind. Die Aufnahmen 3 werden dabei untereinander durch leistenartige, vertikal vorspringende Stege 4 getrennt. Die äußeren Aufnahmen 5 sind jeweils von einem äußeren, vertikal in Bezug auf die vertieften Aufnahmen 3, 5 vorspringenden Rand 6 umgeben, wobei der Rand 6 entsprechend den vier Seiten der rechteckigen Platte 2 vier Randbereiche 7, 8, 9, 10 aufweist, wobei sich die Randbereiche 8, 10 über die gesamte Längsseite des Substratträgers 1 erstrecken.

Aufgrund des, wie im Folgenden noch deutlich werden wird, in den Aufnahmen 3, 5 fehlenden Materials des Substratträgers 1 ist der Substratträger 1 einerseits relativ leicht ausgebildet und weist aufgrund der Stege 4 und des erhöhten Randes 6 eine ausreichend hohe Steifigkeit aus. Außerdem lässt er sich beispielsweise durch Fräsen besonders einfach aus einer kommerziell erhältlichen Robax®-Platte herstellen.

Der Substratträger 1 ist mehrstückig, nämlich dreiteilig ausgebildet und besteht aus zwei Seitenteilen 11 und einem Mittelteil 12. Verbunden sind die einzelnen Teile 11, 12 des Substratträgers 1 entlang von Stegen 4, so dass im Übergangsbereich jeweils zwei Stege 4 aneinanderliegen. Die Verbindung der einzelnen Teile 11, 12 erfolgt über Leisten 13, die mit den Teilen 11, 12 jeweils beispielsweise über eine oder mehrere Schraubverbindungen verbunden sind. Es sind natürlich auch andere lösbare Verbindungen, beispielsweise entlang der benachbarten Stege 4 der einzelnen Teile 11, 12 möglich. Ebenso können die Teile 11, 12 untereinander oder mit der Leiste 13 insbesondere keramisch verklebt sein, wenn auf die Funktion der Lösbarkeit verzichtet werden kann.

In Fig. 2 ist der in Fig. 1 eingekreiste Bereich X vergrößert dargestellt. Es ist ersichtlich, dass der Übergangsbereich zwischen den Randbereichen 8, 9 dahingehend abgerundet ausgeführt ist, dass die auf Aufnahme 5 weisende Kante 14 des Randbereiches 8 tangential in einen halbkreisförmigen Übergang 15 übergeht und der Übergang 15 wiederum senkrecht in die auf Aufnahme 5 weisende Kante 16 des Randbereiches 9 übergeht. In der weiter vergrößerten Darstellung des Bereichs Y in Fig. 3 ist der Übergang 15 noch deutlicher zu erkennen, wobei ersichtlich ist, dass der Übergang 15 sich nicht vollständig durch die Aufnahme 5 erstreckt sondern die Aufnahme 5 eine Auflage 17 für die Substrate aufweist, die durch ein bogenförmiges Element in Form einer Freifräsung gebildet wird. Der Übergang 15 wird somit in Aufnahmerichtung von der Auflage 17 begrenzt.

Durch den Übergang 15 ist ein senkrechtes Aufeinandertreffen der Kanten 14, 16 der Randbereiche 8, 9 verhindert, was zur Verringerung bzw. Verhinderung von insbesondere wärmebedingten Spannungen in diesem Übergangsbereich beiträgt.

Entgegen dieser Ausgestaltung kann der Übergang 15 auch tangential in die Kante 16 übergehen und senkrecht auf die Kante 14 treffen. Ebenfalls zweckmäßig ist ein in beide Kanten 14, 16 tangential übergehender Übergang, der beispielsweise als Viertelkreis ausgebildet ist.

Solche halbkreisförmigen Übergänge 15 und die sie in Aufnahmerichtung begrenzenden Auflagen 17 sind ebenfalls an den Übergangsbereichen zwischen den einzelnen Randbereichen 7, 8 und 8, 9 und 9, 10 sowie 10, 7 vorgesehen und außerdem in den Übergangsbereichen zwischen dem Rand 6 und den Stegen 4 sowie zwischen den Stegen 4 untereinander. Selbstverständlich kann auch vorgesehen sein, dass nicht an allen Kreuzungspunkten solche Spannungsentlastungsübergänge ausgebildet sind.

In Fig. 4 ist schließlich eine Querschnittsansicht des Substratträgers 1 entlang der Linie A in Fig. 2 mit Blick auf die Kante 16 wiedergegeben.

Deutlich zu erkennen ist die Leiste 13, die die drei Teile 11, 12 des Substratträgers miteinander verbindet, wobei die Teile 11, 12 in einer Vertiefung der Leiste 13 an einem Randsteg 18 anliegen.

Die Höhe der Vertiefungen der Auflagen 17 in den Aufnahmen 3, 5 ist der Stärke der Substrate so angepasst, dass die Beschichtung der Substrate nicht etwa durch den Rand 6 und die Stege 4 hervorgerufene Abschattungseffekte beeinträchtigt wird.

Die Auflage 17 der Aufnahmen 3, 5 ist mit einer zentralen Öffnung 19 versehen, die die Handhabung der in der Aufnahme 3, 5 abgelegten Substrate aufgrund einer Durchgriffsmöglichkeit erleichtert. Die Auflage 17 kann jedoch auch durchgehend als umlaufender freigefräster Rand ausgebildet sein, insbesondere um die Stabilität der Auflage 17 und des gesamten Substratträgers 1 zu erhöhen.

Aus der vorliegenden Beschreibung ist deutlich geworden, dass sich ein Substratträger aus Glaskeramik sehr einfach und im Vergleich zu gebräuchlichem CFC-Material kostengünstiger herstellen lässt. Da zudem das glaskeramische Material, wie beispielsweise das bevorzugte Schott Robax®-Material, eine wesentlich kürzere Lieferzeit hat, lassen sich Beschichtungsanlagen wesentlich wirtschaftlicher betreiben. Auch eine einfache Umrüstung schon bestehender Anlagen ist möglich.

## Patentansprüche

1. Beschichtungsanlage, insbesondere für die Herstellung von Solarzellen, umfassend einen Substratträger (1) zur Substratbeschichtung, **dadurch gekennzeichnet, dass** der Substratträger (1) im Wesentlichen aus einem glaskeramischen Material besteht.

2. Beschichtungsanlage gemäß Anspruch 1, **dadurch gekennzeichnet, dass** der Substratträger (1) im Wesentlichen aus dem Material Schott Robax® oder dem Material NeoCeram® N-11 besteht.

3. Beschichtungsanlage gemäß Anspruch 1 oder 2, **dadurch gekennzeichnet, dass** der Substratträger (1) als im Wesentlichen rechteckige Platte (2) ausgebildet ist und auf einer Hauptfläche mehrere Aufnahmen (3, 5) für die Aufnahme von Substraten nebeneinander angeordnet sind.

4. Beschichtungsanlage gemäß Anspruch 3, **dadurch gekennzeichnet, dass** die Aufnahmen (3, 5) Vertiefungen in dem Substratträger (1) aufweisen.

5. Beschichtungsanlage gemäß Anspruch 4, **dadurch gekennzeichnet, dass** die Aufnahmen (3, 5) voneinander durch leistenartige Stege (4) getrennt sind und der Substratträger (1) einen äußeren, die äußeren Aufnahmen (5) begrenzenden stegartigen Rand (6) aufweist.

6. Beschichtungsanlage gemäß Anspruch 5, **dadurch gekennzeichnet, dass** an den Übergängen zwischen den leistenartigen Stegen (4) untereinander, den einzelnen Seitenbereichen (7, 8, 9, 10) des Randes (6) untereinander bzw. den leistenartigen Stegen (4) und dem äußeren Rand (6) abgerundete Übergänge (15) vorgesehen sind, so dass weder die Kanten der leistenartigen Stege (4), noch die Kanten (14, 16) der Randbereiche (7, 8, 9, 10) oder die der leistenartigen Stege (4) und der Randbereiche (7, 8, 9, 10) in einem rechten Winkel aufeinandertreffen.

7. Beschichtungsanlage gemäß Anspruch 6, **dadurch gekennzeichnet, dass** die Übergänge (15) als Halbkreise ausgeführt sind, die sich tangential von einem leistenartigen Steg bzw. Randbereich (8) erstrecken und in einem rechten Winkel in den zu diesem rechtwinklig verlaufenden leistenartigen Steg bzw. Randbereich (9) der jeweiligen Aufnahme (5) übergehen.

8. Beschichtungsanlage gemäß einem der vorherigen Ansprüche, **dadurch gekennzeichnet, dass** der Substratträger (1) mehrstückig ausgebildet ist.

9. Beschichtungsanlage gemäß Anspruch 8, **dadurch gekennzeichnet, dass** der Substratträger (1) entlang der leistenartigen Stege (4) trennbar ausgebildet ist.

10. Beschichtungsanlage gemäß Anspruch 9, **dadurch gekennzeichnet, dass** die einzelnen Teile (11, 12) des Substratträgers über seitliche Leisten (13) miteinander verbunden sind.

11. Beschichtungsanlage gemäß einem der vorherigen Ansprüche, **dadurch gekennzeichnet, dass** die Aufnahmen (3, 5) vertiefte Auflagen (17) für die Substrate auf weisen.

12. Beschichtungsanlage gemäß einem der vorherigen Ansprüche, **dadurch gekennzeichnet, dass** die Aufnahmen (3,5) Durchgriffsöffnungen (19) aufweisen.

13. Beschichtungsanlage gemäß Anspruch 12, **dadurch gekennzeichnet, dass** die Auflagen als an zwei Seiten der Aufnahmen (3, 5) gegenüberliegende U-förmige Rillen ausgebildet sind, deren innere Bögen in der Substratträgerebene ausgerichtet sind, wobei der Abstand der inneren Bögen der in einer Aufnahme (3, 5) gegenüberliegenden U-förmigen Rillen größer und der Abstand der äußeren Enden der in einer Aufnahme (3, 5) gegenüberliegenden U-förmigen Rillen kleiner als die laterale Abmessung des Substrates sind, wobei der Abstand des inneren Bogens einer Rille zu einem äußeren Ende der gegenüberliegenden Rille größer ist als die laterale Abmessung des Substrates.

14. Beschichtungsanlage gemäß Anspruch 13, **dadurch gekennzeichnet, dass** zumindest die der Beschichtungsquelle zugewandten äußeren Enden der in einer Aufnahme (3, 5) gegenüberliegenden U-förmigen Rillen teilweise durchbrochen sind, so dass eine Abschattung des Substrats bei der Beschichtung verringert ist.

15. Verwendung eines glaskeramischen Materials für einen Substratträger (1) für die Substratbeschichtung, insbesondere für einen Substratträger (1) gemäß einem der Ansprüche 1 bis 14.

16. Verwendung gemäß Anspruch 15, **dadurch gekennzeichnet, dass** als glaskeramisches Material Schott Robax® oder NeoCeram® N-11 verwendet wird.
